# EUROPEAN PATENT APPLICATION

(11) **EP 3 627 030 A1**
(43) Date of publication of application: **25.03.2020**
(21) Application number: 18802402.0
(22) Date of filing: 20.04.2018
(51) Int. Cl.: F16L 59/06, H05K 7/20

(54) **HEAT-INSULATING MATERIAL AND HEAT-INSULATING STRUCTURE EMPLOYING SAME**

(30) Priority: 15.05.2017 JP 2017096425
(71) Applicant: Panasonic Intellectual Property Management Co., Ltd., Osaka-shi, Osaka 540-6207 (JP)
(72) Inventor: SAKATANI, Shigeaki, Osaka-shi, Osaka 540-6207 (JP); WADA, Tooru, Osaka-shi, Osaka 540-6207 (JP)
(74) Representative: Vigand, Philippe
(86) International application number: PCT/JP2018/016253
(87) International publication number: WO 2018/211906

(57) **Abstract**

A heat insulating material is used that is a sheet including a fiber and an aerogel. The fiber is aligned in a certain direction in the sheet. A heat insulating structure is used that includes: a high-temperature unit; a cooling unit; and the heat insulating material joining the high-temperature unit and the cooling unit to each other. The certain direction of the heat insulating material is a direction in which the high-temperature unit and the low-temperature unit are joined to each other. A heat insulating structure is used that includes: a first battery cell; a second battery cell; the heat insulating material disposed between the first battery cell and the second battery cell; and a cooling plate that is in contact with the first battery cell, the second battery cell, and the heat insulating material.

## Description

### TECHNICAL FIELD

The technical field relates to a heat insulating material, and to a heat insulating structure using same. Particularly, the technical field relates to a heat insulating material that insulates the heat from a heat-generating component in a range of devices including electronic devices and precision instruments, and to a heat insulating structure using such a heat insulating material.

### BACKGROUND

The heat density of a heat-generating component has greatly increased over the last years along with the increasing performance of electronic devices such as cell phones and laptop personal computers, and a technique for diffusing heat has become essential in these electronic devices. Small mobile devices, in particular, often make direct contact with the body, and the high temperature in outer surfaces of the casing has become a serious issue.

One issue posed by the high temperature in outer surfaces of the casing of a mobile device is low-temperature burn. A low-temperature burn is a type of burn that occurs when the body is exposed to a temperature higher than the body temperature for extended time periods. According to previous reports, a low-temperature burn occurs after 6 hours at 44°C, and the time is halved for every 1°C increase.

Compared to ordinary burns, a low-temperature burn usually becomes noticed after symptoms have developed, and, in most cases, serious damage is caused in the skin by the time the burn becomes noticeable. In recently reported cases, a low-temperature burn is commonly observed after long use of a small laptop computer on the lap. As the development of smaller and more mobile devices continues, it is of utmost importance to reduce temperature increase in a device surface, even by 1°C.

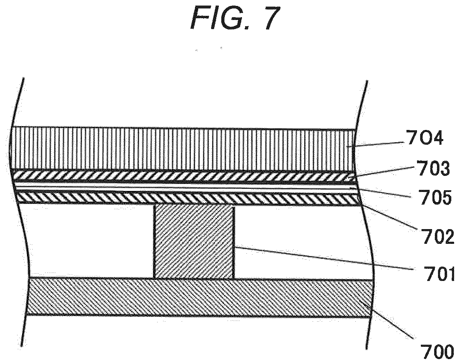

JP-A-2009-111003 discloses a method for preventing temperature increase in a device surface. Specifically, this related art discloses installing a laminate of a graphite sheet and a heat insulating material between a heat-generating component and a casing. FIG. 7 shows a cross sectional view of the structure.

A component 701 is disposed on a substrate 700. A heat conductor 702 and a heat insulator 703 are laminated on the component 701, and a casing 704 is disposed on the top.

The generated heat from the component diffuses in the heat conductor 702. However, the heat does not transfer to the casing 704 through the heat insulator 703. That is, the heat transfers throughout the heat conductor 702, and reaches the casing over a wide area. Accordingly, there is no specific area of the casing 704 that feels hot when touched with hand.

However, a drawback of the structure of the related art above is the need to laminate the heat conductor 702 and the heat insulator 703. While the heat can be expected to diffuse in in-plane direction with the laminate of the heat conductor 702 and the heat insulator 703, it would not be possible to control the direction of heat transfer within the plane.

### SUMMARY

It is accordingly an object of the present disclosure to provide a heat insulating material having anisotropy in heat transfer direction within a plane. The present disclosure is also intended to provide a heat insulating structure using such a heat insulating material.

According to an aspect of the disclosure, a heat insulating material is used that is a sheet containing a fiber and an aerogel, wherein the fiber is aligned in a certain direction in the sheet.

According to another aspect of the disclosure, a heat insulating structure is used that includes:
a high-temperature unit;
a cooling unit; and
the heat insulating material joining the high-temperature unit and the cooling unit to each other,
wherein the certain direction of the heat insulating material is a direction in which the high-temperature unit and the low-temperature unit are joined to each other.

According to another aspect of the disclosure, a heat insulating structure is used that includes:
a first battery cell;
a second battery cell;
the heat insulating material disposed between the first battery cell and the second battery cell; and
a cooling plate that is in contact with the first battery cell, the second battery cell, and the heat insulating material.

With the foregoing aspects of the present disclosure, a composite heat insulator can be provided that can exhibit a sufficient heat insulating effect even in a narrow space inside a casing of an electronic device while effectively reducing transfer of heat from a heat-generating component to the casing. With the aspects of the disclosure, an electronic device can be provided that includes the composite heat insulator.

### BRIEF DESCRIPTION OF THE DRAWINGS

FIG. 1A is a plan view of a fiber sheet of First Embodiment as viewed from above.
FIG. 1B is a cross sectional view of the fiber sheet of First Embodiment as viewed from above.
FIG. 2 is an explanatory diagram concerning fiber alignment direction.
FIG. 3 is a perspective view of a fiber sheet of Second Embodiment.
FIG. 4 is a schematic view representing Comparative Example 1.
FIG. 5 is a cross sectional view of a cooling structure of Example 1 of the disclosure.
FIG. 6 is a cross sectional view of a cooling structure of Example 2 of the disclosure.
FIG. 7 is a cross sectional view showing a heat insulating structure of related art.

### DESCRIPTION OF EMBODIMENTS

### First Embodiment

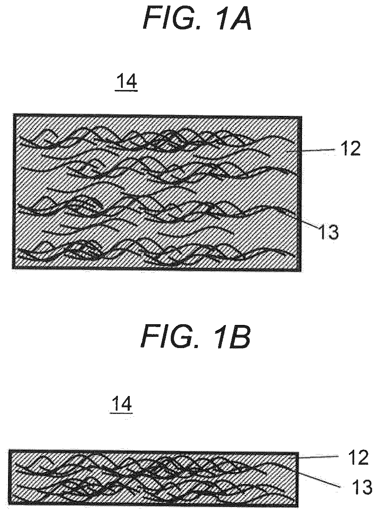

FIG. 1A shows a plan view of a heat insulating material 14 as a heat management member of First Embodiment. FIG. 1B shows a cross sectional view of the heat insulating material 14. FIGS. 1A and 1B depict the heat insulating material 14 in a way that clearly shows the position and shape of a first fiber 13 inside the material.

The heat insulating material 14 of First Embodiment is configured from an aerogel 12 that provides insulation, and the first fiber 13 having the property to more easily conduct heat than the aerogel 12. The first fiber 13 is present by being contained in the aerogel 12.

The aerogel 12 and the first fiber 13 have a thermal conductivity difference. The aerogel 12 has a thermal conductivity of 15 mW/mK to 30 mW/mK.

The first fiber 13 may be an organic fiber, an inorganic fiber, or a metal fiber. The first fiber 13 has a thermal conductivity of preferably 100 mW/mK or more.

With at least a three-fold thermal conductivity difference, heat preferentially propagates in the first fiber 13, and the aerogel 12 provides insulation between the first fibers 13. The heat insulating material 14, despite being a heat insulating material, can therefore provide a device capable of controlling the direction of heat propagation in a way that depends on the alignment of the first fiber 13.

Components of the present disclosure are described below in detail.

### Aerogel 12

The aerogel 12 has a thermal conductivity of about 0.015 W/mK to 0.025 W/mK, a value smaller than the thermal conductivity of air (0.028 W/mK at ordinary temperature).

The aerogel 12 is a foam containing about 85 vol% to 95 vol% of air, and the foam has a pore size smaller than the mean free path, 68 nm, of air (nitrogen). This enables the aerogel 12 to maintain low thermal conductivity.

The aerogel 12 may have a form of a monolith (a bulk), a block, a sheet, a powder, a fiber, or a granule. From a thermal conductivity standpoint, it is preferable that the aerogel 12 be densely packed.

The aerogel 12 is synthesized from a variety of base materials, for example, such as carbon, cellulose, and silica. For heat resistance and electrical insulation, silica is selected as a base material in the present embodiment.

Silica aerogel has an average pore size of 10 to 67 nm, a pore volume of 3.5 to 8 cc/g, and a specific surface area of 500 to 900 m²/g. The pore is smaller than the mean free path, 68 nm, of air.

The average pore size is preferably 10 to 50 nm, more preferably 10 to 30 nm. The pore volume is preferably 5 to 8 cc/g, more preferably 6 to 8 cc/g. The bulk density is 90 to 250 kg/m³, preferably 120 to 180 kg/m³, more preferably 140 to 150 kg/m³. A thermal conductivity of 0.025 W/mK or less is required to provide insulation.

A silica aerogel having an average pore size, a specific surface area, and a bulk density in these ranges provides desirable insulation, and is preferred for use as the heat insulating material.

A common feature of silica aerogel is transparency. However, in order to control radiation factor or reduce static electricity, for example, fine carbon particles may be added, provided that its influence on thermal conductivity is negligible.

Water glass (a sodium silicate aqueous solution) may be used as a starting material of the silica aerogel, and the silica aerogel can be prepared in a controlled fashion by adjusting the silicate concentration of the water glass, the type and concentration of the acid used for gelation, and gelation conditions (temperature, time, and pH). Hydrophobization conditions can be controlled by adjusting an amount of silylation agent, an amount of solvent, temperature, and time. Drying conditions can be controlled by adjusting, for example, drying temperature, and time.

The water glass as raw material of the silica aerogel is prepared so that the silica concentration is 4 to 20 weight% with respect to the total sol weight. For cost considerations, lower silica concentrations are preferred. For strength, higher silica concentrations are preferred.

When the silicate concentration is 4 weight% or less, the wet gel skeleton cannot have sufficient strength because of the low silicate concentration. With a silicate concentration of more than 20%, the sol solution gels at a rapidly increased rate, and it may not be possible to control production.

Preferably, the water glass is one prepared by drying under ordinary pressure. It is, however, possible to prepare water glass by supercritical drying.

The starting raw material may be an alkoxysilane material such as TEOS and MTMS. A silica aerogel prepared from such materials can provide thermal conductivity, strength, and transparency similar to those of the silica aerogel prepared from water glass, provided that the material is subjected to a suitable chemical treatment at an appropriate concentration using a catalyst.

For strength, a component that functions as a paste may be added to increase the bond strength between particles of aerogel 12.

Typical examples of such materials that function as a paste include water glass, PVA, a water-soluble binder containing acryl as a main component, and a phenolic resin.

From a thermal conductivity standpoint, the paste content needs to be 10% or less, preferably 5% or less of the weight of the aerogel 12.

When the paste content is 10% or more, the thermal conductivity exceeds 30 mW/mK. This is no different from providing an air layer, and it is not possible to take advantage of using the aerogel 12.

### First Fiber 13

The first fiber 13 of the embodiment may be a resin fiber such as glass wool, glass paper, rock wool, and polyester; a cellulose fiber such as a cellulose nanofiber; a pulp fiber; a carbon fiber; a metal fiber such as a copper, an aluminum, and a silver fiber, or a composite fiber of these and other fibers. The first fiber 14 is selected taking into consideration factors such as heatproof temperature and flame retardance in use.

In the case where the aerogel 12 is mixed into the first fiber 13 in a sol state, it is preferable to use a fiber, for example, a glass wool or a cellulose fiber, having high compatibility with sol. In this way, the aerogel 12 and the first fiber 13 can have good wettability, and mix with each other with ease.

For materials that are not readily mixable, it is preferable to alter wettability by adding a surfactant, a wetting agent, or a viscosity adjuster.

With regards to shape, the first fiber 13 is a short cut fiber measuring about 1 mm to 51 mm in length. The first fiber 13 is a mixture of fibers of the same or different diameters ranging from 1 µm to 50 µm.

Because the heat insulating material 14 requires strength, it is preferable that the first fiber 13 be intertwined. To this end, the first fiber 13 is preferably crimped. Crimping is a process by which the fibers are woven into a mesh pattern. In crimping, the fibers are waved, and vertically and horizontally fitted to one another to form a clump of fibers. The fiber may be simply entwined, instead of being woven. In situations where crimping cannot be easily accomplished, it is possible to mix a low-melting-point fiber that can fuse at relatively low temperatures, in order to provide the effect of a reinforcing agent.

An aggregate of first fibers 13 retains a large body of air, and, traditionally, the heat insulating effect is obtained by taking advantage of the insulation provided by such an air layer. However, because the air layer is partly convective, the air layer is replaced with the aerogel 12 to reduce such a convective component.

The amount of first fiber 13 varies with factors such as the amount of heat that needs to be insulated, and the acceptable thickness.

### Heat Insulating Material 14

Heat preferentially propagates in the first fiber 13 in the heat insulating material 14 prepared as a mixture of the aerogel 12 and the first fiber 13. This allows for control of heat flow direction with controlled directions of the first fiber 13. That is, the heat insulating material 14 insulates heat in a certain direction while transferring heat in a fiber direction.

The heat insulating material 14 cannot have sufficient strength when the extent of intertwining of the first fiber 13 is small. The aerogel 12 itself is a weak material, and is not strong enough to complement a lack of strength in the heat insulating material 14.

As such, the necessary strength is basically provided by the first fiber 13 in the heat insulating material 14. In the heat insulating material 14, anisotropy is provided by increasing the anisotropy of the first fiber 13, which transfers heat.

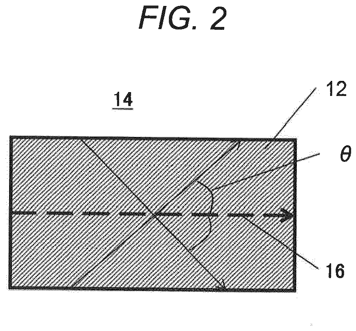

The alignment direction of the first fiber 13 is described below, with reference to FIG. 2. FIG. 2 is a magnified cross sectional view of the heat insulating material 14.

The first fiber 13 is aligned in a certain direction 16 parallel to a plane (surface) of the heat insulating material 14 (the certain direction 16 is a plane direction of a sheet in the case of a sheet) . Heat transfers in the certain direction 16 but is insulated in a direction perpendicular to the certain direction 16. Preferably, at least 80% of the first fibers 13 are confined within an angle θ of ±45 degrees with respect to the certain direction 16. Here and below, angle θ refers to all angles created with respect to an axis along the certain direction 16.

### Method of Production

The following describes a method for producing the heat insulating material 14 of First Embodiment.

### Overview

The process starts with a sol preparation step, in which water glass as a raw material of the aerogel 12 is brought to a gelation pH after removing sodium from the water glass.

In the next impregnation step, the first fiber 13 is impregnated with the sol solution before the sol turns into a gel.

This is followed by a curing step, which forms a strong silica skeleton that can withstand the capillary force exerted on the inner wall of the gel when drying the solvent.

The next step is hydrophobization, in which the gel surface is hydrophobized with a silylation agent or functional silane to prevent contraction due to dehydrocondensation hydroxyl groups on the inner wall of the gel at the time of drying.

This is followed by drying, in which the solvent in the fibrous heat insulating material is removed.

The first fiber 13 is used in the form of a mass of anisotropic first fibers 13 prepared in advance in the manner described below.

### Pretreatment of First Fiber 13

The first fiber 13, which is a nonwoven fabric, is unidirectionally aligned. Typically, this is achieved by using a technique called a spunlace method, or a water-jet intertwining method as it is also called.

The spunlace method is a wet method that forms a web of first fibers 13, and intertwines the first fibers 13 under a high-pressure water jet. An advantage of this method is that it can form a nonwoven fabric that has the soft texture and the drape of fabric, and the homogeneity of paper. The spunlace method is used for production of a range of products from wiping cloths to battery separators.

The direction of first fiber 13 can be controlled by controlling the flow rate of water in the spunlace method. Intertwining of first fiber 13 also can be adjusted by controlling the flow rate of water.

When the first fiber 13 has a thermal conductivity ratio of 4 or more with respect to the thermal conductivity of the aerogel 12, it is preferable that at least 80% of the first fibers 13 be confined in an angle θ of ±45 degrees with respect to the certain direction 16 of the first fiber 13.

When the first fiber 13 has a thermal conductivity ratio of less than 4 with respect to the thermal conductivity of the aerogel 12, it is preferable that at least 90% of the first fibers 13 be confined in an angle θ of ±45 degrees with respect to the certain direction 16 of the first fiber 13.

In this way, more heat transfers in an in-plane direction than in a thickness direction of the heat insulating material, and the heat insulating material can have anisotropy in heat conduction.

The certain direction 16 of the first fiber 13 varies with the state of crimping of the first fiber 13, and is not limited to the one described above. The benefits of the present embodiment should still be obtained even when the first fibers 13 are aligned slightly less.

### Sol Preparation

The water glass aqueous solution used in the embodiment is prepared as a 5 to 20 weight% solution, preferably a 10 to 20 weight% solution, more preferably a 15 to 20 weight% solution. When the silicate concentration in the aqueous solution is less than 5%, the low silicate concentration may result in a wet gel skeleton lacking sufficient strength. When the silicate concentration is more than 20%, it may not be possible to control gelation as a result of rapid gelation of the sol solution.

The water glass used to produce the aerogel 12 is used after removing the sodium contained therein. The water glass may be any of Class 1 water glass (silica concentration of 35 to 38 weight%), Class 2 water glass (silica concentration of 34 to 36%), and Class 3 water glass (silica concentration of 28 to 30%) (as specified by Japanese Industrial Standards (JIS K1408)).

Sodium is removed from the water glass aqueous solution by removing the sodium contained in the water glass, using an acidic ion exchanger. To remove sodium, the water glass is mixed with a protic ion-exchange resin, and the mixture is stirred until the pH of the water glass aqueous solution becomes 1 to 3. Thereafter, a base is added to bring the pH to 5 to 8, a pH range that enables gelation. Typical examples of the base include ammonia, ammonium hydroxide, sodium hydroxide, and aluminum hydroxide. Preferred for adjustability is ammonia.

Alternatively, for sol preparation, a sodium salt may be formed using an acid, and the generated hydrogel may be washed to remove the salt. In this case, an acid is added in 10 to 30 weight% of the weight of the water glass, and the gel is washed after curing until the electrolyte is no longer present.

Examples of the acid used include inorganic acids such as hydrochloric acid, nitric acid, sulfuric acid, hydrofluoric acid, sulfurous acid, phosphoric acid, phosphorous acid, hypochlorous acid, chloric acid, chlorous acid, and hypochlorous acid; acidic phosphates such as acidic aluminum phosphate, acidic magnesium phosphate, and acidic zinc phosphate; and organic acids such as acetic acid, propionic acid, oxalic acid, succinic acid, citric acid, malic acid, and adipic acid.

Preferred for the strength of the gel skeleton of the resulting aerogel 12 is hydrochloric acid.

The solution used for washing may be a water-soluble solvent, for example, such as purified water, methanol, ethanol, and propanol.

A uniform hydrogel also may be produced without using a sodium-containing water glass as a starting raw material but by using a colloidal silica solution (pH = 10 to 11) that has undergone grain growth, and by adding the acid to the solution to adjust the pH to 5 to 8, a pH range that enables gelation. The amount of the acid catalyst added varies with the target value of adjusted pH. In the case of hydrochloric acid, it is preferable to add 0.5 to 5.0%, more preferably 1 to 2.5% of a 12 N hydrochloric acid aqueous solution with respect to the weight of hydrogel taken as 100%.

### Fiber Introduction

The first fiber 13 in the form of a nonwoven fabric is impregnated with the adjusted sol solution. As required, the excess liquid is squeezed out of the nonwoven fabric to adjust the amount of liquid in the nonwoven fabric, using a roller or the like. Here, it is preferable to squeeze out the trapped air at the same time so that the liquid is present throughout the nonwoven fabric.

### Curing

After the impregnation of the adjusted sol solution in the heat insulating material 14, it is required to promote polycondensation of the silica colloid, and growth of secondary particles so that the heat insulating material 14 can have strength strong enough to withstand the capillary force exerted at the time of drying. After the sol impregnated in the heat insulating material 14 has turned into a gel, the heat insulating material 14 is heat cured in a temperature range that does not cause evaporation of water from the sheet, specifically, at a temperature of 70 to 95°C, preferably 80 to 95°C, more preferably 90 to 95°C. This is to promote polycondensation of silica particles, and growth of secondary particles.

The curing time is 2 to 24 hours, preferably 6 to 24 hours, more preferably 12 to 24 hours. The necessary curing time can be reduced by curing the heat insulating material 14 under high temperature and high pressure.

### Hydrophobization

The silylation agent used when a silica nanofiber 2 is added is a silane represented by general formula R¹R²₂SiCl or R¹ₙSi(OR²)₄₋ₙ (where R¹ and R² independently represent C1 to C6 linear alkyl, cyclic alkyl, or phenyl, alkoxysilane). Hexamethyldisiloxane (HMDSO), and hexamethyldisilazane (HMDS) are also suitable.

Here, the silane representing a silylation agent belongs to a group of silicon compounds configured from chlorosilane, alkoxysilane, and silazane. Specifically, in this case, alkoxysilane is preferred in terms of compatibility with the solvent, which is selected from alcohols, ketones, and linear aliphatic hydrocarbons. The silylation agent is an organosilicon compound prepared from an organic compound containing an active hydrogen that can be substituted with a Si atom. The active hydrogen is substituted with a Si atom.

The silylation agent causes substitution of active hydrogen with silicon, for example, in the hydroxyl group, the amino group, the carboxyl group, the amide group, and the mercapto group of an organic compound.

When using the cellulose nanofiber 2, the cellulose becomes degraded when hydrochloric acid generates in the hydrophobization solution. To prevent this, hydrophobization is carried out with R¹ₙSi(OR²)₄₋ₙ (where R¹ and R² independently represent C1 to C6 linear alkyl, cyclic alkyl, or phenyl), or with hexamethyldisilazane (HMDS) .

Preferred as R¹R²₂SiCl is trimethylchlorosilane (TMCS). Preferred as R¹ₙSi(OR²)₄₋ₙ is trimethylmethoxysilane.

When using HMDSO, HCl may be mixed in a molar ratio of 0.02 to 2.0 with respect to the used amount of HMDSO to generate an active species TMCS in the reaction system. In this case, the concentration of the hydrochloric acid aqueous solution is preferably 1 to 12 N, more preferably 10 to 12 N.

The silylation agent is used in an amount of preferably 100 to 800%, more preferably 100 to 300% with respect to the pore volume of the hydrogel.

The hydrophobization reaction is carried out in a solvent, if need be. Typically, the reaction is carried out at 20 to 100°C, preferably 30 to 60°C. When the reaction temperature is less than 20°C, the silylation agent may fail to sufficiently diffuse, and hydrophobization may not properly take place.

Preferred examples of the solvent include alcohols such as methanol, ethanol, and 2-propanol; ketones such as acetone, and methyl ethyl ketone; and linear aliphatic hydrocarbons such as pentane, hexane, and heptane. The gel before hydrophobization is hydrophilic, whereas the silylation agent is a hydrophobic solvent. It is accordingly preferable to use an alcohol or a ketone, which are amphiphatic solvents, and therefore enable the active species silylation agent to efficiently react with the hydrogel.

The hydrophobization time is preferably 2 to 24 hours, more preferably 2 to 12 hours.

### Drying

The sheet after hydrophobization is dried at 100 to 150°C for 2 to 5 hours to evaporate the solvent contained in the impregnated sheet. Here, when the heatproof temperature of the resin in the base heat insulating material 14 is equal to or less than the drying temperature, the sheet may be dried after replacing the solvent with a solvent having a boiling point equal to or less than the heatproof temperature of the resin fiber. Examples of such solvents include alcohols such as methanol, ethanol, and 2-propanol; ketones such as acetone, and methyl ethyl ketone; pentane; and hexane.

### Effects

Despite being a single member, the heat insulating material 14 obtained after these steps can orient the heat transfer direction in a desired direction, and is highly effective as a sheet for use particularly in spaces as narrow as 1 mm or less. This is because the sheet can have improved insulation when it is made thicker.

The heat insulating material 14 also can semi-permanently maintain its thermal property even when used after being cut as desired.

### Second Embodiment

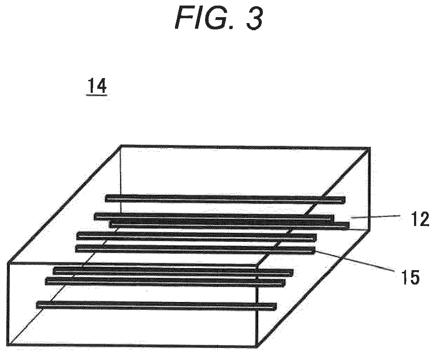

FIG. 3 shows a perspective view of a heat insulating material 14 of Second Embodiment. The aerogel 12 is shown as being transparent. Anything that is not described is the same as in First Embodiment.

The heat insulating material 14 of the present Second Embodiment is configured from an aerogel 12 that provides insulation, and a second fiber 15 having the property to more easily conduct heat than the aerogel 12.

A difference from First Embodiment is the second fiber 15, specifically intertwining of fibers.

More specifically, as can be seen from comparison of FIG. 3 and FIGS. 1A and 1B, the second fibers 15 are not in contact with one another, and are not intertwined, as shown in FIG. 3.

As used herein, "fibers being intertwined" refers to a state in which lifting one fiber in an empty space lifts another fiber. Specifically, the second fiber 15 is a straight fiber.

The second fiber 15 is typically a fiber, for example, a ceramic fiber, that has high tensile strength but is brittle in property. The second fibers 15 are not flexible, and do not intertwine. When strength is needed, the second fiber 15 may be reinforced by providing a resin binder on the fiber surface, as required.

The second fiber 15 may itself be treated with a resin binder in advance, or the binder may be applied at a later time to increase strength.

For anisotropy, preferably at least 80% of the second fibers 15 are confined in an angle θ of ±45 degrees with respect to the certain direction 16 of the second fiber 15.

When the second fiber 15 has a thermal conductivity ratio of 4 or more with respect to the thermal conductivity of the aerogel 12, it is preferable that at least 80% of the second fibers 15 be confined in an angle θ of ±45 degrees with respect to the certain direction 16 of the second fiber 15.

When the second fiber 15 has a thermal conductivity ratio of less than 4 with respect to the thermal conductivity of the aerogel 12, it is preferable that at least 90% of the second fibers 15 be confined in an angle θ of ±45 degrees with respect to the certain direction 16 of the second fiber 15.

In this way, more heat transfers in an in-plane direction than in a thickness direction of the heat insulating material 14, and the heat insulating material 14 can have anisotropy in heat conduction.

When introduction of a binder component is not easily possible from a standpoint of heat resistance and chemical resistance, a fiber material, for example, such as a glass fiber and an organic fiber, that can be crimped and easily intertwined may be additively mixed, as required.

Second Embodiment, which differs from First Embodiment in the second fiber 15, is described below in detail with regards to configurations that differ from First Embodiment. Other configurations are the same as in First Embodiment, and will not be described.

### Second Fiber 15

The second fiber 15 of the embodiment may be, for example, a glass fiber, an alumina fiber, a metal fiber, a carbon fiber, or a composite fiber of these and other fibers. The second fiber 15 may be selected taking into consideration factors such as heatproof temperature and flame retardance in use.

In the case where the silica aerogel is mixed into the second fiber 15 in a sol state, it is preferable to use a fiber having high compatibility with sol. Such fibers have good wettability, and can easily mix with the aerogel.

When the second fiber 15 is not readily mixable, it is preferable to alter wettability by adding a surfactant, a wetting agent, or a viscosity adjuster.

With regards to shape, the second fiber 15 is a unidirectionally aligned long fiber. The second fiber 15 may be a chopped fiber obtained by cutting such a long fiber into a desired length.

For example, an alumina long fiber may be cut into a predetermined length according to use. An alumina long fiber has many desirable properties, including high tension, high elastic modulus, high heat resistance, high corrosion resistance, high electrical insulation, and high dimensional stability, in addition to being weakly hygroscopic and having a smooth surface. Because the fiber is cut from a continuous fiber, the fiber has a more uniform diameter and length than short fiber products, and includes fewer shots (shape defects).

Alumina long fibers may be bundled with a sizing agent such as PVA and EVA, and cut into a pellet shape of a predetermined length. The fiber also has potential industrial applications as an FRP or other reinforcing materials when combined with various materials.

The cut length may be less than 1 mm to several hundred millimeters, though it depends on use. The fiber may be a single fiber having a diameter of 1 µm to 5 mm, or a mixture of a plurality of fibers of these diameters.

A low-melting-point fiber that can fuse at relatively low temperatures may be mixed to provide the effect of a reinforcing agent.

### Method of Production

A method for producing the heat insulating material 14 of Second Embodiment is described below. The method of Second Embodiment differs from First Embodiment only in the fiber introducing step, and the following only describes this step. The other steps do not differ from First Embodiment, and will not be described. The second fiber 15 is added to the sol prepared in the sol preparation step, without pretreating the fiber.

### Introduction of Second Fiber 15

In Second Embodiment, the second fiber 15 is introduced to an adjusted sol solution prepared beforehand. The second fiber 15 is mixed into the sol from the sol preparation step to prepare a uniform suspension of second fibers 15. Thereafter, the mixture is run in a certain direction, and the second fibers 15 are aligned in a flow direction of the adjusted sol solution. The sheet is then adjusted to the desired thickness through a gap coater.

The sheet is allowed to stand at room temperature for about 15 minutes to allow for gelation.

In this method, the second fiber 15 are aligned using a flow of the suspension containing the second fiber 15. However, the sheet may be formed by coating the suspension using a coater or the like.

The other steps are the same as in First Embodiment, and are not described.

Despite being a single member, the heat insulating material 14 obtained after these steps can orient the heat transfer direction in a desired direction, and is highly effective as a sheet for use particularly in spaces as narrow as 1 mm or less.

The heat insulating material 14 also can semi-permanently maintain its thermal property even when used after being cut as desired.

### Example 1

A sheet of heat insulating material 14 was produced in the manner described in First Embodiment. An oxidized acrylic fiber of desirable properties having flame retardance and a diameter of about 10 µm was used as the first fiber 13. Though the thermal conductivity of the oxidized acrylic fiber itself is not easily measurable, the oxidized acrylic fiber has a thermal conductivity of about 0.15 mW/mK, a value not greatly different from the thermal conductivity of an ordinary acrylic resin. A nonwoven fabric produced by using the spunlace method had a basis weight of 100 g/m², and an average thickness of 0.9 mm.

With regards to the orientation angle of the first fiber 13, it is preferable that 80 weight% of the first fibers 13 be confined within an angle θ of ±45 degrees with respect to the certain direction of the first fiber 13, as described with reference to the schematic view of FIG. 2.

The first fiber 13 and the aerogel 12 had a weight ratio of about 1:1 as measured in the final product.

The aerogel 12 was introduced into the first fiber 13 using the method described in First Embodiment. The resulting heat insulating material 14 had a thermal conductivity of 0.02 W/mK.

### Comparative Example 1

In Comparative Example 1, a test sample was produced by more randomly disposing the first fiber 13 than in Example 1, that is, without orienting the first fiber 13.

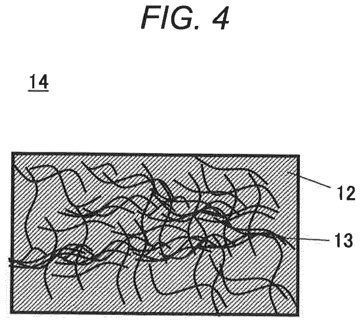

FIG. 4 schematically represents Comparative Example 1. The heat insulating material 14 had a thermal conductivity of 0.02 W/mK, as in Example 1.

### Evaluation 1

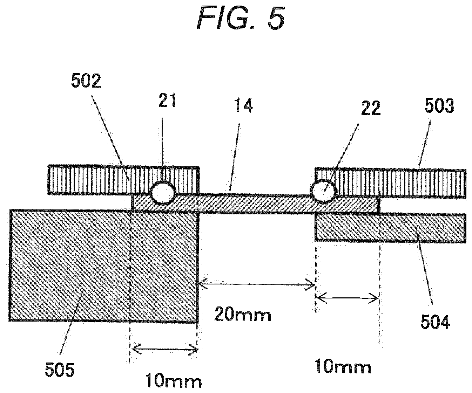

A cooling structure was produced to examine the effects of the present disclosure. The cross sectional view of FIG. 5 schematically shows the cooling structure.

The heat insulating material 14, measuring 40 mm in width and 40 mm in length, was placed on a hot plate 505. As shown in FIG. 5, the heat insulating material 14 was disposed on the hot plate 505 only in a 10-mm portion of its length, offsetting the remaining 30 mm. The heat insulating material 14 was fixed with a first ceramic plate 502, a second ceramic plate 503, and a third ceramic plate 504.

The hot plate 505 was used as a heat source, and the surface temperature of the hot plate 505 was set to 180°C (first measurement point 21). With the heat insulating material 14 hanging out from an end of the hot plate 505, a temperature was measured at a location (second measurement point 22) 20 mm away from the end of the hot plate 505. The average temperature over a time period of 2 minutes was measured to find the heat transfer capability of the heat insulating material 14.

Typically, a measurement principle commonly referred to as a steady-state method is used for thermal conductivity measurement of the heat insulating material 14. An example of the steady-state method is the HFM method, which measures thermal conductivity by the amount of transferred heat after evenly balancing temperature on upper and lower surfaces. However, heat transfer capability can be examined also in a plane direction of the heat insulating material 14 with the measurement system shown in FIG. 5.

In Example 1, the measured temperature was 95°C at the first measurement point 21 on the first ceramic plate 502 above the hot plate 505. The second measurement point 22 had a temperature of 40°C, creating a temperature difference of 55°C.

In Comparative Example 1, the measured temperature was 97°C at the first measurement point 21 on the first ceramic plate 502 above the hot plate 505. The second measurement point 22 had a temperature of 35°C, creating a temperature difference of 62°C. The result showed that more transfer of heat took place in Example 1.

The experiment demonstrated that the heat insulating material, despite using the aerogel 12, enabled transfer of heat through control of fiber alignment direction. Compared to the resin fiber used in the experiment, a greater effect should be obtained when a metal fiber is used.

### Example 2

A sheet of heat insulating material 14 was produced in the manner described in Second Embodiment. A carbon fiber of desirable properties having heat resistance and a diameter of about 3 µm was used as the second fiber 15. The carbon fiber is a PAN fiber, and had a nominal thermal conductivity of about 100 W/mK. The fiber had a basis weight of 100 g/m², and an average thickness of 0.5 mm per unit area.

The alignment direction of the second fiber 15 was controlled by adjusting the speed of a gap coater. In Example 2, a sheet was formed at a rate of 30 mm/s because the viscosity of the suspension made it difficult to control alignment direction at a coater speed of less than 15 mm/s.

With regards to the orientation angle of the second fiber 15, at least 90 weight% of the second fibers 15 were confined within an angle θ of ±45 degrees with respect to the certain direction 16, as described with reference to the schematic view of FIG. 2.

The second fiber 15 and the aerogel 12 had a weight ratio of about 1:1 as measured in the final product.

The second fiber 15 was introduced into the aerogel 12 using the method described in Second Embodiment. The resulting heat insulating material 14 had a thermal conductivity of 0.022 W/mK.

### Comparative Example 2

In Comparative Example 2, a test sample was produced by more randomly disposing the fiber than in Example 2, that is, without orienting the fiber. The heat insulating material 14 had a thermal conductivity of 0.022 mW/mK.

### Evaluation 2

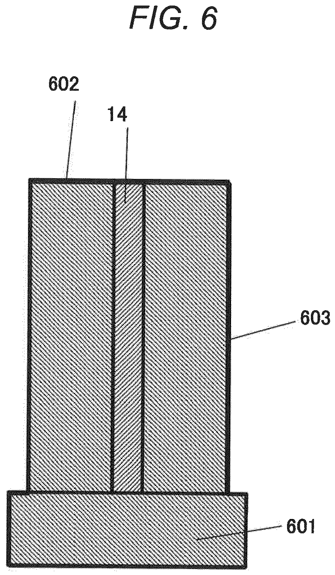

FIG. 6 shows a cross sectional view of a structure using the heat insulating material. In this Example, the structure is a battery cell cooling structure for lithium secondary battery. The structure was evaluated for its cooling function against abnormal heat generation of the battery.

The evaluation system is as follows. A high-temperature aluminum cell 602 and an aluminum cell 603 were disposed on a cooling plate 601.

The heat insulating materials 14 from samples of Example 2 and Comparative Example 2 were each placed between the high-temperature aluminum cell 602 and the aluminum cell 603.

The time before the temperature of the high-temperature aluminum cell 602 leveled off was measured in each structure.

The high-temperature aluminum cell 602 represents a battery generating abnormal heat. The cooling plate 601 represents a chiller. The aluminum cell 603 represents an ordinary battery.

A sample from Example 2 was placed between the high-temperature aluminum cell 602 and the aluminum cell 603 in such an orientation that the alignment direction of the first fiber 13 was directed toward the cooling plate 601.

The room temperature was 23°C. The initial temperature of the aluminum cell 603 was also 23°C. The high-temperature aluminum cell 602 was preheated to 100°C. The cooling plate 601 was cooled to maintain a constant temperature of 20°C.

The cells 602 and 603 had a constant temperature of 20°C after 20 minutes in the structure installed with the sample of Example 2. The cells 602 and 603 had a constant temperature of 20°C after 25 minutes in the structure installed with the sample of Comparative Example 2.

The time to reach a uniform temperature was different between Example 2 and Comparative Example 2, despite that the heat insulating materials 14 had the same thermal conductivity, 0.022 W/mK.

As demonstrated above, the structure of Example 2 had a higher cooling capability than the structure of Comparative Example 2, even though the heat insulating materials used in these examples had the same insulation performance. The heat insulating material 14 used is the heat insulating material of First Embodiment. However, the same result will be obtained with the heat insulating material of Second Embodiment.

### Final Note

First Embodiment and Second Embodiment may be combined. The first fiber 13 and the second fiber 15 may be contained in the same heat insulating material 14.

### INDUSTRIAL APPLICABILITY

As described above, the present disclosure can provide a composite heat insulator that can exhibit a sufficient heat insulating effect even in a narrow space inside a casing of an electronic device while effectively reducing transfer of heat from a heat-generating component to an outer surface of the casing. The disclosure also can provide an electronic device that includes the composite heat insulator.

### Reference Signs List

- 12: AEROGEL
- 13: FIRST FIBER
- 14: HEAT INSULATING MATERIAL
- 15: SECOND FIBER
- 16: CERTAIN DIRECTION
- 21: FIRST MEASUREMENT POINT
- 22: SECOND MEASUREMENT POINT
- 502: FIRST CERAMIC PLATE
- 503: SECOND CERAMIC PLATE
- 504: THIRD CERAMIC PLATE
- 505: HOT PLATE
- 601: COOLING PLATE
- 602: HIGH-TEMPERATURE ALUMINUM CELL
- 603: ALUMINUM CELL
- 700: SUBSTRATE
- 701: COMPONENT
- 702: HEAT CONDUCTOR
- 703: HEAT INSULATOR
- 704: CASING

## Claims

1. A heat insulating material as a sheet that comprises a fiber and an aerogel,
wherein the fiber is aligned in a certain direction in the sheet.

2. The heat insulating material according to claim 1, wherein the fiber represents fibers at least 80% of which are aligned in a direction within 90 degrees with respect to the certain direction.

3. The heat insulating material according to claim 1, wherein the fiber represents intertwining first fibers.

4. The heat insulating material according to claim 1, wherein the fiber represents non-intertwining second fibers.

5. The heat insulating material according to claim 1, wherein the fiber represents fibers that include intertwining first fibers and non-intertwining second fibers.

6. The heat insulating material according to claim 1, wherein the certain direction is parallel to a surface of the sheet.

7. A heat insulating structure comprising:
a high-temperature unit;
a low-temperature unit; and
the heat insulating material of claim 1 joining the high-temperature unit and the low-temperature unit to each other,
wherein the certain direction of the heat insulating material is a direction in which the high-temperature unit and the low-temperature unit are joined to each other.

8. A heat insulating structure comprising:
a first battery cell;
a second battery cell;
the heat insulating material of claim 1 disposed between the first battery cell and the second battery cell; and
a cooling plate that is in contact with the first battery cell, the second battery cell, and the heat insulating material.
